# DEMANDE DE BREVET EUROPEEN

(11) **EP 4 310 910 A1**
(43) Date de publication de la demande: **24.01.2024**
(21) Numéro de dépôt: 23184556.1
(22) Date de dépôt: 10.07.2023
(51) Int. Cl.: H01L 27/02, H01L 21/306, H01L 21/02

(54) **DISPOSITIF ELECTRONIQUE DE PROTECTION ESD**

(30) Priorité: 18.07.2022 FR 2207307
(71) Demandeur: STMicroelectronics (Tours) SAS, 37100 Tours (FR)
(72) Inventeur: ARNAUD, Aurelie, 37540 SAINT-CYR-SUR-LOIRE (FR); LADROUE, Julien, 37380 MONNAIE (FR)
(74) Mandataire: Cabinet Beaumont

(57) **Abrégé**

La présente description concerne un procédé de fabrication d'un dispositif de protection contre des surtensions, comportant les étapes successives suivantes :
a) former, par épitaxie, sur un substrat semiconducteur (13), une couche semiconductrice (19) ;
b) exposer la face supérieure de la couche semiconductrice (19) à un traitement plasma fluoré ; et
c) former une couche électriquement isolante (27) sur et en contact avec la face supérieure de la couche semiconductrice (19) .

## Description

### Domaine technique

La présente description concerne de façon générale les dispositifs électroniques et, plus particulièrement, les dispositifs électroniques de protection contre des surtensions, par exemple contre des décharges électrostatiques ou ESD (de l'anglais "ElectroStatic Discharge").

### Technique antérieure

On connaît différents dispositifs de prévention et de protection contre les décharges électrostatiques.

### Résumé de l'invention

Il existe un besoin d'améliorer les performances des dispositifs de protection contre les décharges électrostatiques actuels.

Un mode de réalisation prévoit un procédé de fabrication d'un dispositif de protection contre des surtensions, comportant les étapes successives suivantes :
a) former, par épitaxie, sur un substrat semiconducteur, une couche semiconductrice ;
b) exposer la face supérieure de la couche semiconductrice à un traitement plasma fluoré ; et
c) former une couche électriquement isolante sur et en contact avec la face supérieure de la couche semiconductrice.

Selon un mode de réalisation, le procédé comporte, avant l'étape a), une étape de formation d'une première région semiconductrice de type de conductivité opposé à celui du substrat, dans une dans une partie supérieure du substrat.

Selon un mode de réalisation, la jonction PN entre la première région semiconductrice et le substrat forme une diode Zener du dispositif de protection.

Selon un mode de réalisation, le procédé comporte, après l'étape a) et avant l'étape b), une étape de formation d'une deuxième région semiconductrice de type de conductivité opposé à celui de la couche semiconductrice, dans une partie supérieure de la couche semiconductrice.

Selon un mode de réalisation, la jonction PN entre la couche semiconductrice et la deuxième région semiconductrice forme une diode du dispositif de protection.

Selon un mode de réalisation, la couche semiconductrice est de type de conductivité opposé à celui du substrat.

Selon un mode de réalisation, la couche semiconductrice présente un niveau de dopage compris entre 1.10¹³ atomes/cm³ et 1.10¹⁵ atomes/cm³.

Selon un mode de réalisation, le plasma appliqué à l'étape b) est un plasma de fluorure de carbone.

Selon un mode de réalisation, le plasma appliqué à l'étape b) est un plasma à couplage inductif.

Selon un mode de réalisation, la couche électriquement isolante est une couche d'oxyde de silicium.

Selon un mode de réalisation, le substrat et la couche semiconductrice sont en silicium.

Selon un mode de réalisation, le substrat est dopé de type N et la couche semiconductrice est dopée de type P.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F et la figure 1G représentent des étapes d'un mode de mise en oeuvre d'un procédé de fabrication d'un dispositif de protection contre les décharges électrostatiques ; et
la figure 2 est une représentation graphique illustrant un exemple d'évolution de capacités parasites présentes dans le dispositif illustré en figure 1G. Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications que peuvent avoir les circuits de protection ESD décrits n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas" , "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

On s'intéresse ici tout particulièrement à des dispositifs de protection ESD à structure verticale, comportant un empilement vertical de régions semiconductrices de dopages distincts définissant par exemple des diodes de protection contre les ESD connectées en série ou en anti-série, surmonté d'une couche d'isolation, par exemple à base d'un oxyde.

On s'intéresse notamment à des dispositifs de protection ESD à faible capacité parasite. Dans ce cas, la couche d'isolation supérieure est généralement en contact avec une couche semiconductrice très peu dopée. Le procédé de formation de la couche isolante peut entraîner le piégeage de charges électriques à l'interface entre la couche semiconductrice très peu dopée et la couche d'isolation. Ces charges conduisent à dégrader les performances du dispositif de protection ESD et notamment à augmenter sa capacité parasite, en particulier pour des signaux basse fréquence.

Selon un aspect d'un mode de réalisation, on prévoit de traiter la surface de la couche semiconductrice supérieure au moyen d'un plasma fluoré avant la formation de la couche d'isolation, de façon à limiter le piégeage de charges à l'interface avec la couche d'isolation et ainsi réduire la capacité parasite du dispositif, notamment pour des signaux basse fréquence.

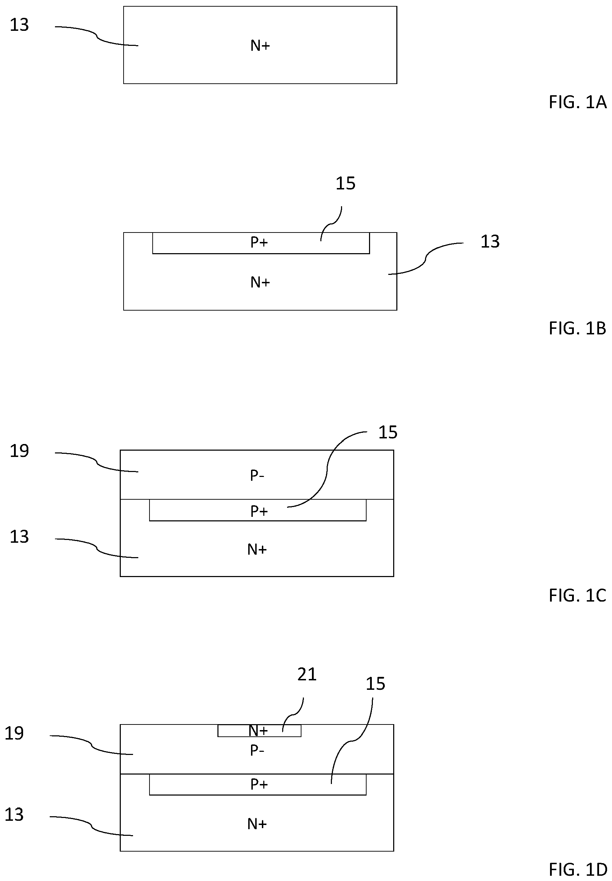

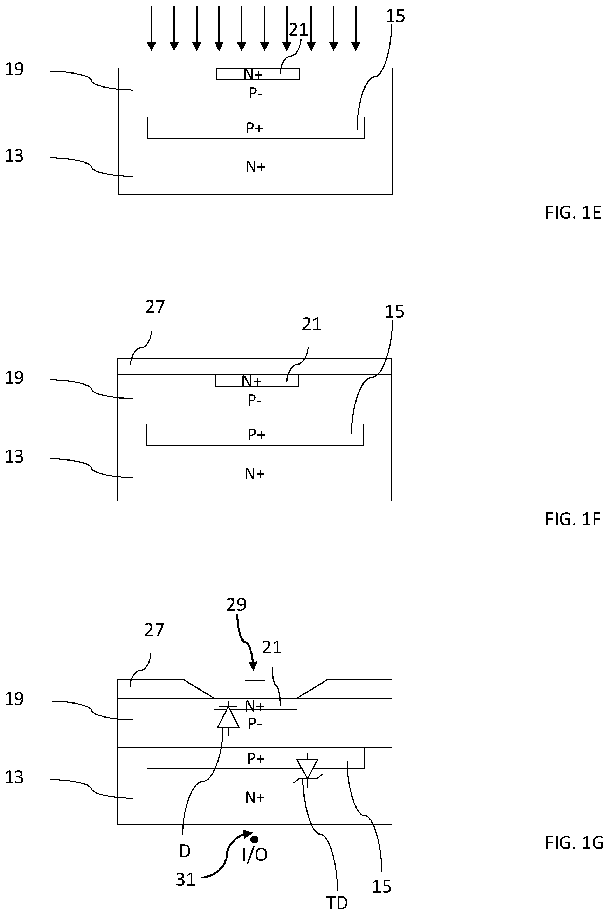

La figure 1A, la figure 1B, la figure 1C, la figure 1D, la figure 1E, la figure 1F et la figure 1G sont des vues en coupe illustrant des étapes successives d'un mode de mise en oeuvre d'un procédé de fabrication d'un exemple d'un dispositif de protection contre les décharges électrostatiques.

La figure 1A représente une structure de départ comprenant un substrat 13.

Le substrat 13 est, par exemple, en un matériau semiconducteur d'un premier type de conductivité, par exemple de type N. A titre d'exemple, le substrat 13 est fortement dopé de type N, par exemple de niveau de dopage compris entre 2.10¹⁹ atomes/cm³ et 7.10¹⁹ atomes/cm³. Le substrat 13 est, par exemple, en silicium.

La figure 1B illustre une structure obtenue à l'issue d'une étape de formation, dans une partie supérieure du substrat 13, d'une zone semiconductrice 15 de type de conductivité opposée à celui du substrat.

La zone 15 est, par exemple, formée dans le substrat 13 de façon à ce qu'elle affleure une face, la face supérieure dans l'orientation de la figure 1B, du substrat 13.

La zone 15 est par exemple formée par implantation d'éléments dopants du côté de la face supérieure du substrat 13. A titre d'exemple, l'implantation est localisée sur une partie seulement de la surface du substrat 13. Ainsi, dans cet exemple, la zone 15 s'étend sur une partie seulement de la surface du substrat 13. Le niveau de dopage de la zone 15 est par exemple comprise entre 1.10¹⁷ atomes/cm³ et 1.10¹⁹ atomes/cm³. L'épaisseur de la zone 15 est par exemple comprise entre 1 µm et 4 µm.

Dans la suite de la description, on considère la face supérieure de la structure ou d'une couche, dans l'orientation de la figure 1B, comme étant la face avant et la face inférieure de la structure ou d'une couche, dans l'orientation de la figure 1B, comme étant la face arrière.

La figure 1C illustre une structure obtenue à l'issue d'une étape de formation d'une couche semiconductrice 19 sur la face avant de la structure illustrée en figure 1B.

Lors de cette étape, la couche 19 est formée pleine plaque sur la face avant de la structure, c'est-à-dire qu'elle est formée sur toute la surface de la face supérieure du substrat 13 et de la zone 15. La couche 19 a, par exemple, une épaisseur sensiblement constante sur l'ensemble de la surface de la structure. La couche 19 a, par exemple, une épaisseur comprise entre 8 µm et 15 µm, par exemple égale à environ 12 µm.

La couche 19 est, par exemple, du même type de conductivité que la zone 15, par exemple de type P. A titre d'exemple, le niveau de dopage de la couche 19 est inférieur à celui de la zone 15. La couche 19 est de préférence très faiblement dopée. Le niveau de dopage de la couche 19 est par exemple compris entre 1.10¹³ atomes/cm³ et 1.10¹⁵ atomes/cm³. Ainsi, le matériau de la couche est de préférence fortement résistif. A titre d'exemple, le matériau de la couche 19 a une conductivité électrique comprise entre 10 Ω.cm et 200 Ω.cm, voire supérieure à 200 Ω.cm.

La couche 19 est par exemple en le même matériau que le substrat 13, par exemple en silicium. A titre d'exemple, la couche 19 est formée par épitaxie sur et en contact avec la surface supérieure de la structure de la figure 1B.

La figure 1D illustre une structure obtenue à l'issue d'une étape de formation, dans une partie supérieure de la couche 19, d'une deuxième zone semiconductrice 21 de type de conductivité opposé à celui de la couche 19, par exemple de type N.

La zone 21 est, par exemple, formée dans la couche 19 de façon à ce que la face avant de la zone 21 affleure la face avant de la couche 19. La zone 21 est, par exemple, située à l'aplomb de la zone 15. A titre d'exemple, le centre de la zone 21 est aligné verticalement avec le centre de la zone 15.

La zone 21 est par exemple formée par implantation d'éléments dopants du côté de la face supérieure de la couche 19. A titre d'exemple, l'implantation est localisée sur une partie seulement de la surface du substrat 13. Ainsi, dans cet exemple, la zone 21 s'étend sur une partie seulement de la couche 19. A titre d'exemple, la zone 21 s'étend, dans le plan de la face avant de la structure, sur une surface inférieure à la surface de la zone 15.

Le niveau de dopage de la zone 21 est par exemple équivalent à celui du substrat 13. A titre d'exemple, le niveau de dopage de la zone 21 est comprise entre 1.10¹⁹ atomes/cm³ et 1.10²⁰ atomes/cm³. L'épaisseur de la zone 21 est par exemple comprise entre 0,8 µm et 4 µm.

La figure 1E illustre une étape de traitement de la surface supérieure de la couche 19 au moyen d'un plasma fluoré. Lors de cette étape, on vient implanter des atomes de fluor dans une partie superficielle de la couche 19, par exemple à l'extrême surface de la couche 19.

A titre d'exemple, le plasma est un plasma de fluorure de carbone, les atomes de carbone permettant d'éviter une gravure de la couche 19 pendant le traitement. A titre d'exemple, le plasma est en tétrafluorure de carbone (CF4), en octafluorocyclobutane (C4f8) ou en trifluorométhane (CHF3).

A titre d'exemple, le traitement plasma est réalisé sur toute la surface de la face avant de la structure.

De préférence, lors de cette étape, un plasma à couplage inductif est utilisé. A titre d'exemple, la puissance de polarisation du substrat permettant l'accélération des ions à la surface est supérieure à 50 W, par exemple supérieure à 100 W.

La figure 1F illustre une structure obtenue à l'issue d'une étape de dépôt d'une couche électriquement isolante ou couche de passivation 27 sur la face avant de la structure illustrée en figure 1E.

La couche 27 est par exemple déposée pleine plaque sur toute la surface de la structure. La couche 27 a par exemple une épaisseur sensiblement constante sur l'ensemble de sa surface. A titre d'exemple, l'épaisseur de la couche 27 est comprise entre 1 µm et 4 µm, par exemple égale à environ 2 µm.

A titre d'exemple, la couche 27 est en un oxyde, par exemple un oxyde de silicium, par exemple en USG (de l'anglais "Undoped Silicate Glass", verre de silicate non dopé), en TEOS (orthosilicate de tétraéthyle) ou en un oxyde thermique. A titre d'exemple, la couche 27 est formée par dépôt chimique en phase vapeur ou CVD (de l'anglais "Chemical Vapor Déposition) comme un dépôt chimique en phase vapeur assisté par plasma (PECVD, Plasma-Enhanced Chemical Vapor Deposition) ou un dépôt chimique en phase vapeur à basse pression (LPCVD, Low Pressure Chemical Vapor Déposition). Ce dépôt est, par exemple, suivi d'un recuit de la couche 27.

La figure 1G illustre une structure obtenue à l'issue d'une étape de gravure localisée de la couche 27 à partir de la structure illustrée en figure 1F.

Lors de cette étape, on vient former, par exemple, une ouverture traversante dans la couche 27 et ainsi découvrir une portion de la zone 21.

A titre d'exemple, la gravure est effectuée de sorte que les flancs de l'ouverture soient obliques et que l'ouverture se rétrécisse avec sa profondeur. En d'autres termes, en figure 1G, l'ouverture est plus étroite au niveau de la face avant de la zone 21 qu'au niveau de la face avant de la couche 27.

A titre d'exemple, la gravure est effectuée par photolithographie puis gravure.

Dans la structure illustrée en figure 1G, la jonction PN horizontale entre la zone 15 et le substrat 13, forme une diode Zener TD, par exemple une diode connue sous la dénomination commerciale Transil, dont l'anode est formée par la zone 15 et la cathode correspond au substrat 13. Les niveaux de dopage respectifs du substrat 13 et de la zone 15 définissent la tension d'avalanche de la diode Zener TD, et ainsi la tension de déclenchement du dispositif de protection ESD.

La jonction PN horizontale entre la couche 19 et la zone 21, forme quant à elle une diode D dont la cathode correspond à la zone 21 et l'anode correspond à la couche 19. Dans ce mode de réalisation, la diode D et la diode Zener TD sont connectées en anti-série.

A titre d'exemple, la zone 21 du dispositif 1G est destinée à être connectée à la masse 29, et le substrat 13 est destiné à être connecté à un plot d'entrée/sortie 31 (I/O) d'un dispositif à protéger.

Le dispositif de protection peut comprendre des métallisations de connexion, non représentées, en contact respectivement avec la face supérieure de la zone 21 (à travers l'ouverture formée dans la couche 27) et avec la face inférieure du substrat 13, permettant de connecter le dispositif à un dispositif extérieur à protéger.

Le dispositif peut en outre comprendre une troisième diode (non représentée) connectée en direct entre la masse 29 et le plot d'entrée/sortie 31. Cette troisième diode est par exemple formée par la jonction PN entre la couche 19 et le substrat 13. En cas de surtension positive sur le plot 31, la diode Zener entre en avalanche et la surtension est évacuée vers la masse 29 par l'intermédiaire de la diode D qui conduit alors en direct. En cas de surtension négative sur le plot 31, la surtension est évacuée vers la masse 29 par l'intermédiaire de la troisième diode (non représentée) qui conduit alors en direct.

Un avantage du procédé décrit en relation avec les figures 1A à 1G est que le traitement plasma à base de fluor (figure 1E) mis en oeuvre avant la formation de la couche isolante 27 (figure 1F) permet de compenser les pièges présents à l'interface entre la couche 19 et la couche 27, et ainsi limiter le piégeage de charges électriques à l'interface entre la couche 19 et la couche 27. Ceci permet de réduire la capacité parasite du dispositif de protection ESD.

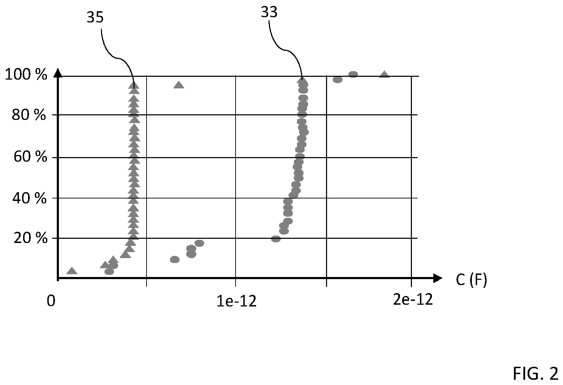

La figure 2 est une représentation graphique illustrant un exemple d'évolution de capacités parasites présentes dans le dispositif illustré en figure 1G.

Plus particulièrement, la figure 2 illustre l'évolution de la distribution (en %, en ordonnée) de la capacité parasite C de la diode D, (en Farad (F), en abscisse), avec ou sans application du traitement plasma décrit en relation avec la figure 1E.

Le graphique de la figure 2 comprend deux courbes : une première courbe 33 représentant la distribution de la capacité parasite et de la capacité de jonction de la diode D lorsque le traitement plasma de la figure 1E n'est pas mis en oeuvre ; et
une deuxième courbe 35 représentant la distribution de la capacité parasite et de la capacité de jonction de la diode D lorsque le traitement plasma de la figure 1E est mis en oeuvre.

Ces allures montrent que la prévision du traitement plasma fluoré permet de diminuer la capacité parasite d'environ 66 %. Dans cet exemple, en l'absence du traitement plasma, la capacité parasite moyenne mesurée de la diode D est d'environ 1,5 pF. En présence du traitement plasma, la capacité parasite moyenne mesurée est d'environ 0,5 pF.

Un avantage du présent mode de réalisation est que l'implantation d'atomes de fluor en surface de la couche 19 permet de limiter le piégeage de charges électriques parasites (et notamment de charges parasites positives dans le cas d'une couche 19 faiblement dopée de type P) à l'interface avec la couche 27.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-avant.

En outre, les modes de réalisation décrits ne se limitent pas à l'exemple particulier de structure de protection ESD décrite en relation avec la figure 1G, mais s'appliquent, plus généralement, à tout dispositif de protection ESD intégré dans et sur un substrat semiconducteur.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif de protection contre des surtensions, comportant les étapes successives suivantes :
a) former, par épitaxie, sur un substrat semiconducteur (13) en silicium, une couche semiconductrice (19) en silicium ;
b) exposer toute la surface supérieure de la couche semiconductrice (19) en silicium à un traitement plasma fluoré ; et
c) former une couche électriquement isolante (27) sur et en contact avec toute la surface supérieure de la couche semiconductrice (19) en silicium.

2. Procédé selon la revendication 1, comportant, avant l'étape a), une étape de formation d'une première région semiconductrice (15) de type de conductivité opposé à celui du substrat (13), dans une partie supérieure du substrat (13) .

3. Procédé selon la revendication 2, dans lequel la jonction PN entre la première région semiconductrice (15) et le substrat (13) forme une diode Zener (TD) du dispositif de protection.

4. Procédé selon l'une quelconque des revendications 1 à 3, comprenant, après l'étape a) et avant l'étape b), une étape de formation d'une deuxième région semiconductrice (21) de type de conductivité opposé à celui de la couche semiconductrice (19), dans une partie supérieure de la couche semiconductrice (19).

5. Procédé selon la revendication 4, dans lequel la jonction PN entre la couche semiconductrice (19) et la deuxième région semiconductrice (15) forme une diode (D) du dispositif de protection.

6. Procédé selon l'une quelconque des revendications 1 à 5, dans lequel la couche semiconductrice (19) est de type de conductivité opposé à celui du substrat (13).

7. Procédé selon l'une quelconque des revendications 1 à 6, dans lequel la couche semiconductrice (19) présente un niveau de dopage compris entre 1.10¹³ atomes/cm³ et 1.10¹⁵ atomes/cm³.

8. Procédé selon l'une quelconque des revendications 1 à 7, dans lequel le plasma appliqué à l'étape b) est un plasma de fluorure de carbone.

9. Procédé selon l'une quelconque des revendications 1 à 8, dans lequel le plasma appliqué à l'étape b) est un plasma à couplage inductif.

10. Procédé selon l'une quelconque des revendications 1 à 9, dans lequel la couche électriquement isolante (27) est une couche d'oxyde de silicium.

11. Procédé selon l'une quelconque des revendications 1 à 10, dans lequel le substrat (13) et la couche semiconductrice (19) sont en silicium.

12. Procédé selon l'une quelconque des revendications 1 à 11, dans lequel le substrat (13) est dopé de type N et la couche semiconductrice (19) est dopée de type P.

13. Procédé selon l'une quelconque des revendications 1 à 12, dans lequel l'étape b) comprend un traitement de toute de la face supérieure de la couche semiconductrice (19) avec un plasma de fluorure de carbone, de façon à implanter des atomes de fluor dans une partie de la surface de la couche semiconductrice (19), sans graver la couche semiconductrice (19).
